(19) Europäisches Patentamt
European Patent Office
Office européen des brevets

(11) Publication number: **0 421 388 A2**

(12) **EUROPEAN PATENT APPLICATION**

(21) Application number: **90118981.1**

(51) Int. Cl.5: **G03F 7/023**, G03F 7/16

(22) Date of filing: **04.10.90**

The application is published incomplete as filed (Article 93 (2) EPC). The point in the description or the claim(s) at which the omission obviously occurs has been left blank.

(30) Priority: **03.10.89 JP 257040/90**
**30.03.90 JP 80828/90**

(43) Date of publication of application:
**10.04.91 Bulletin 91/15**

(84) Designated Contracting States:
**DE FR GB NL**

(71) Applicant: **MITSUBISHI PETROCHEMICAL CO., LTD.**
**5-2, Marunouchi 2-chome**
**Chiyoda-ku Tokyo(JP)**

(72) Inventor: **Nakano, Yoshitomo**
**Mitsubishi Petrochemical Co. Ltd., 1 Toho-cho**
**Yokkaichi-shi, Mie(JP)**
Inventor: **Himori, Shunichi**
**Mitsubishi Petrochemical Co. Ltd., 1 Toho-cho**
**Yokkaichi-shi, Mie(JP)**
Inventor: **Kada, Masumi**
**Mitsubishi Petrochemical Co. Ltd., 1 Toho-cho**
**Yokkaichi-shi, Mie(JP)**
Inventor: **Ito, Satoshi**
**Mitsubishi Petrochemical Co. Ltd., 1 Toho-cho**
**Yokkaichi-shi, Mie(JP)**

(74) Representative: **Hansen, Bernd, Dr. Dipl.-Chem. et al**
**Hoffmann, Eitle & Partner Patent- und Rechtsanwälte Arabellastrasse 4**
**W-8000 München 81(DE)**

(54) **Positive-acting photoresist composition.**

(57) A positive-acting photoresist composition is described comprising

(a) 100 to 5 parts by weight of an AB or ABA block copolymer comprising a high molecular linear segment with a degree of polymerization in the range of 20 to 5,000 as derived from carboxy group (inclusive of anhydride thereof)-free and amino group-free radical polymerizable unsaturated monomors and a high molecular linear segment with a degree of polymerizaiton in the range of 20 to 5,000 as derived from radical polymerizable unsaturated monomers containing at least 40 mole % of a carboxy group (inclusive of anhydride thereof)- or amino group-containing radical polymerizable unsaturated monomer,

(b) 0 to 95 parts by weight of an alkali-soluble polyphenol, and

(c) 1 to 100 parts by weight of a positive sensitizer.

EP 0 421 388 A2

# POSITIVE-ACTING PHOTORESIST COMPOSITION

## FIELD OF THE INVENTION

The present invention relates to a positive-acting photoresist composition for use in the formation of a printed circuit or an image by the etching technique. The composition of the invention is not only useful for the fabrication of a dry laminate film but also finds application in the manufacture of a positive-acting photoresist electrodeposition coating capable of yielding a tack-free smooth resist film.

## BACKGROUND OF THE INVENTION

The conductor circuit pattern for the manufacture of a printed circuit board is generally formed by using a photoresist film, whereby even a complicated circuit can be formed on a high-production scale with accuracy and at low cost today.

The ordinary circuit board has heretofore been manufactured by the following processes. Thus, a substrate board clad with copper foil is first coated with a light-sensitive photoresist and, then, irradiated with ultraviolet light through a transparent film mask carrying a circuit pattern superimposed on the resulting coating layer. A latent image is formed in this way. The mask is then removed, followed by development with a washing fluid, such as an organic solvent, water or an aqueous solution of alkali, whereby a pattern is formed. The photoresist obtained when the unexposed area is removed leaving the exposed area behind, in the above process, is called a negative-acting photoresist and the photoresist obtained when the exposed area is removed, with the unexposed area remaining intact, is called a positive-acting photoresist. Then, the copper in the area not covered with the resist is removed with an etching solution. The residual copper constitutes a circuit pattern.

Recently, photoresists each consisting of a couple of polyester or other film supports and a photoresist composition (dry film) sandwiched therebetween has been made available. Such a dry film photoresist can be laminated to a copper-clad substrate to provide a photoresist layer on the substrate board. Compared with the wet resist system in which a substrate board is coated with a solution of the photoresist in an organic solvent, the above dry resist system is advantageous in that the production process is simplified to insure improved productivity.

As the dry film photoresist, the negative-acting type of photoresist has heretofore been mostly employed. U.S. Patent 3,469,982, for instance, teaches a process for manufacturing a negative-acting dry film photoresist which comprises polymerizing an acrylic or methacrylic acid ester and adding a polymerizable acrylic monomer thereto. This negative-acting resist is too low in resolution to meet the recent demand for more sophisticated fine-line circuit patterns.

As a positive-acting dry film photoresist representing an improvement over the above earlier photoresist, U.S. Patent 4,193,797 discloses a positive-acting dry film photoresist which can be obtained by adding 2-diazo-1-naphthol-4-sulfonyl chloride to a methyl methacrylate-hydroxydiethyl methacrylate copolymer or adding a positive bisdiazonium salt, (a sensitizer) to a methyl methacrylate-hydroxyethyl methacrylate copolymer.

U.S. Patent 4,571,374 discloses a positive-acting dry film photoresist obtainable by adding propylene glycol and 2,4-dihydroxybenzophenone-bis[naphthoquinone-(1,2)-diazide-(2)-5-sulfonate] to a mixture of a phenol-formaldehyde novolak resin, a styrene-ethyl acrylate-acrylic acid copolymer and an isocyanate compound.

However, since the prior art negative-acting photoresist takes advantage of the photopolymerization reaction of acryl groups, an inhibition of curing due to oxygen is inevitable. In order to prevent this inhibiton of curing, attempts have been made to eliminate the influence of oxygen at exposure by means of an oxygen-impermeable film or through the use of various additives. However, such techniques tend to sacrifice the line definition or resolution, thus failing to meet the recent demand for finer or delicate circuit patterns.

On the other hand, any positive-acting photoresist is inherently free from said oxygen-induced inhibition of curing and, as such, can be conducive to a delicate pattern. However, the conventional positive dry film is deficient in flexibility so that it tends to be cracked by the impact of bonding to the copper-clad substrate or fail to bond intimately, thus causing the exfoliation problem. This is because, since this resin (an acrylic

or methacrylic copolymer resin in many cases) contains a carboxy group-containing comonomer such as acrylic acid, methacrylic acid and/or maleic acid for imparting alkali solubility, the flexibility of the resin is adversely affected by the copolymerizaiton of such comonomers.

If, in an attempt to impart flexibility to the resin, an acrylic or methacrylic ester having an alcohol residue containing a large number of carbon atoms is copolymerized, the glass transition temperature (Tg) of the copolymer is decreased so that the resin becomes sticky and, when a patterned mask film is superimposed thereon for exposure, the resist film adheres to the mask to cause fouling.

On the other hand, the formation of a film by electrodeposition has been proposed to overcome the disadvantages of the dry film laminating technology, i.e. lack of sharpness of the circuit pattern due to the thickness of the film and the difficulty of uniform lamination, particularly the coverage of through-hole areas. For use in this technology, too, a resist composition free from the above-mentioned disadvantages is being demanded.

## SUMMARY OF THE INVENTION

An object of thè present invention is to provide a positive-acting photoresist composition capable of yielding a dry film which is so high in flexibility and adhesion that it can be intimately bonded to a substrate board having surface irregularities and is virtually tack-free in the neighborhood of room temperature, and to which a mask film for the printing of an image can be intimately to insure a sharp print and, hence, provide an image pattern of high resolution.

The present invention is therefore directed to a positive-acting photoresist composition containing the following components (a) through (c) in the indicated proportions:

(a) 100 to 5 parts by weight of an AB or ABA block copolymer comprising a high molecular linear segment with a degree of polymerization in the range of 20 to 5,000 as derived from carboxy group (inclusive of anhydride thereof)-free and amino group-free radical polymerizable unsaturated monomers and a high molecular linear segment with a degree of polymerization in the range of 20 to 5,000 as derived from radical polymerizable unsaturated monomers containing at least 40 mole % of a carboxy group (inclusive of anhydride thereof)- or amino group-containing radical polymerizable unsaturated monomer,

(b) 0 to 95 parts by weight of an alkali-soluble polyphenol, and

(c) 1 to 100 parts by weight of a positive sensitizer.

The term 'ABA block copolymer' as used herein means not only an ABA block copolymer but also a block copolymer of ABAB or ABABA... type.

It should also be understood that in the AB or ABA block copolymer according to the present invention, any of the high molecular linear segments may be A (or B).

## DETAILED DESCRIPTION OF THE INVENTION

In the following detailed description of the invention, the carboxy group (inclusive of anhydride thereof; the same applies hereinafter)-free and amino group-free radical polymerizable unsaturated monomer in the block copolymer of the invention is represented by $M^1$ for one monomer unit and the radical polymerizable unsaturated monomer containing at least 40 mole % of a carboxy group- or amino group-containing radical polymerizable unsaturated monomer is represented by $M^2$ for one monomer unit. Therefore, the high molecular linear segment with a degree of polymerization in the range of 20 to 5,000 as derived from said carboxy group-free and amino group-free radical polymerizable unsaturated monomers can be represented by the formula $\{M^2\}_n$, wherein the degree of polymerization m = 20 to 5,000). On the other hand, the high molecular linear segment with a degree of polymerization in the range of 20 to 5,000 as derived from said radical polymerizable unsaturated monomers containing at least 40 mole % of a carboxy group- or amino group-containing radical polymerizable unsaturated monomer can be represented by the formula $\{M^2\}_n$, wherein the degree of polylmerization n = 20 to 5,000).

Schematiclaly, the AB or ABA block copolymer according to the present invention can be representesd by the following respective formulae, and these block copolymers can invariably be used in the working of the invention. (In the following formulae, each of m, n, i, j, k and ℓ means a degree of polymerization within the range of 20 to 5,000)

$$-(M^1)_m-(M^2)_n-$$

$$-(M^1)_m-(M^2)_n-(M^1)_i-$$

$$-(M^2)_n-(M^1)_m-(M^2)_j-$$

$$-(M^1)_m-(M^2)_n-(M^1)_i-(M^2)_j-$$

$$-(M^1)_m-(M^2)_n-(M^1)_i-(M^2)_j-(M^1)_k-\cdots$$

$$-(M^2)_n-(M^1)_m-(M^2)_j-(M^1)_i-(M^2)_\ell-\cdots$$

The $(M^1)_m$ segment constituting one of the components of the block copolymer according to the present invention can be produced by polymerizing carboxy group-free and amino group-free radical polymerizable unsaturated monomers. As such monomer, any of the carboxy group-free and amino group-free compounds selected from among the monomers mentioned in JP-A-61-287915 and JP-A-64-26619 (The term "JP-A" as used herein means an "unexamined published Japanese patent application") can be employed. Examples of such monomer are acrylic or methacrylic acid esters of $C_{1-12}$ alkyl alcohol (such as methyl acrylate, ethyl acrylate, butyl acrylate, 2-ethylhexyl acrylate, dodecyl acrylate, methyl methacrylate, ethyl methacrylate, etc.), or $C_{7-12}$ aryl alcohol (such as benzyl acrylate, ethylphenyl methacrylate), or alkyl ether

esters, methacrylic esters and so on. For the formation of the $(M^2)_n$ segment by copolymerizing an unsaturated dibasic acid with such an alternate polymerizable monomer, it is necessary to employ a monomeric mixture containing at least 40 mole % of such unsaturated dibasic acid.

The amino group-containing monomer may be a monomer of the general formula

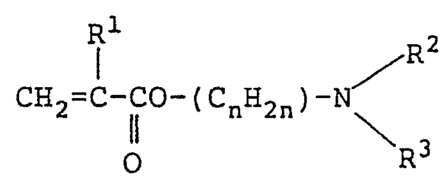

wherein n is an integer of 1 to 6; $R^1$ is a hydrogen atom or a methyl group; $R^2$ and $R^3$ each is a hydrogen atom or a $C_{1-4}$ alkyl group. Specific examples of such monomer are aminoethyl (meth)acrylate, N-tert-butylaminoethyl (meth)acrylate, N,N-dimethylaminoethyl (meth)acrylate, N,N-diethylaminoethyl (meth)-acrylate, N,N-diemthylaminopropyl (meth)acrylate, and N,N-dimethylaminobutyl (meth)acrylate. Particularly preferred are N,N-dimethylaminoethyl (meth)acrylate, N,N-diethylaminoethyl (meth)acrylate, N,N-dimethylaminopropyl (meth)acrylate and N,N-dimethylaminobutyl (meth)acrylate. The term '(meth)acrylate' as used in this specification collectively means acrylate and methacrylate.

The high molecular linear segment with a degree of polymerization in the range of 20 to 5,000 as derived from the radical polymerizable unsaturated monomers containing at least 40 mole % of an amino group-containing radical polymerizable unsaturated monomer in the AB or ABA block copolymer, that is to say the segment which may for example be $(M^2)_n$, can also be obtained by the steps of polymerizing

glycidyl group-containing radical polymerizable unsaturated monomers, such as glycidyl (meth)acrylate, glycidyl (meth)acrylamide, allyl glycidyl ether or the like, as the radical polymerizable monomer for formation of the high molecular linear segment and subjecting the resulting polymer to addition reaction with an amine, preferably a secondary amine such as lower dialkylamines (e.g. dimethylamine, diethylamine, di-Npropylamine, etc.), a dialkanolamine or N-alkylalkanolamine (e.g. diethanolamine, diisopropanolamine, N-methylethanolamine, etc.), or a cyclic amine (e.g. piperidine, morpholine, N-methylpiperazine, etc.) so as to introduce amino groups into the high molecular linear segment.

As a method for production of the block copolymer according to the invention, there is known a photopolymerization process using a dithiocarbamate group-containing compound as the initiator as disclosed in JP-A-64-26619.

With regard to the dithiocarbamate group-containing initiator, the monofunctional dithiocarbamate compound giving rise to an AB block copolymer includes, inter alia, n-butyl N,N-dimethyldithiocarbamate, benzyl N-ethyldithiocarbamate and so on.

The bifunctional dithiocarbamate initiator giving rise to an ABA block copolymer includes, inter alia, N,N,N′,N′-tetramethylthiuram tetrasulfide, N,N,NN′-tetraethylthiuram tetrasulfide, [p-xylenebis(N,N-dimethyldithiocarbamate)] and so on. As the trifunctional dithiocarbamate compound which can be likewise employed include 1,2,3-tris(N,N-dimethyldithiocarbamyl)propane and the tetrafunctional dithiocarbamate compound may for example be [1,2,4,5-tetrakis(N,N-diethyldithiocarbamylmethyl)benzene].

The block copolymer of the invention can also be produced by the method employing a polymeric peroxide or polymeric azo compound as disclosed in JP-A-61-287915. As an example of said polymeric peroxide, there may be mentioned a compound of the formula

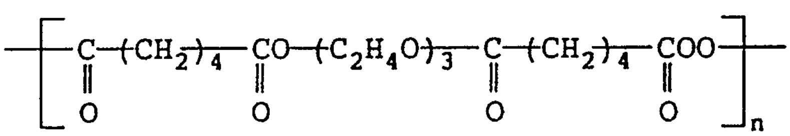

wherein n = 4.5

However, the former method using a dithiocarbamate compound as the initiator is preferable in view of the lower yield of the by-product homopolymer.

The alkali-soluble polyphenol (b) in the present invention may be a novolak polyphenol which can be obtainable by polycondensaiton of phenol compounds and aldehydes in the presence of an acid catalyst or an alkali-soluble species of the polyphenol which is obtainable by polymerizing hydroxy-aromatic-substituted unsaturated monomers.

Among these, novolak polyphenols having a number average molecular weight not less than 1,500 which are exemplarily obtained by polycondensation method described in U.S. Patent 4,876,324 are preferable in that the resulting photoresist is high in chemical resistance and accurate in contrast.

The starting phenol to be used in the production of said novolak polyphenol includes, among others, phenol, $C_{1-9}$ alkyl-substituted monophenols (e.g. o-, m- or p-cresol, butylphenol, xylenol, nonylphenol, etc.), halogen-substituted monophenols (e.g. chlorophenol, bromophenol, etc.), diphenols (e.g. resorcinol, catechol, hydroquinone, 2-methylresorcinol, 1,3-dihydroxy-4-bromobenzene, etc.), bisphenols (e.g. 2,2-bis(4-hydroxydiphenyl)propane, bis(4-hydroxydiphenyl)methane, bis(4-hydroxyphenyl)ether, 2,2- bis(4-hydroxyphenyl)butane and so on. The bisphenols are particularly advantageous in that the bisphenol-based photoresist composition of the invention is excellent in flexibility.

The starting material aldehyde compound for the production of the novolak polyphenol include, among others, formaldehyde, alkylaldehydes (e.g. acetaldehyde, propionaldehyde, etc.), arylaldehydes (e.g. benzaldehyde, etc.) and hydroxy-aromatic-aldehydes (e.g. salicylaldehyde, 4-hydroxybenzaldehyde, vanillin, 3-bromo-4hydroxybenzaldehyde, etc.). The hydroxy-aromatic aldehydes are particularly desirable in that the resulting photoresist composition of the invention is high in sensitivity.

The hydroxy-aromatic-substituted unsaturated monomer for use as a starting material in the production of said alkali-soluble polyphenol (b) in the present invention includes, among others, vinylphenol, isopropylphenol, etc. The polymerization of these monomers can be conducted in the conventional manner.

The positive sensitizer (c) to be incorporated in the photoresist composition of the present invention is preferably a positive sensitizer which is transformable to a more acidic state on exposure to light. As such sensitizer, a quinone diazide compound such as a 1,2- quinone diazide sulfonic acid ester is generally employed. This compound can be easily prepared by reacting a hydroxy-containing low molecular or high molecular compound with benzoquinonediazide-sulfonyl chloride or naphthoquinonediazide-sulfonyl chloride.

The hydroxy-containing low molecular compound mentioned above includes, among others, hydroquinone, resorcin, chloroglycine, 2,4-dihydroxybenzophenone, 2,3,4-trihydroxybenzophenone and so on. The hydroxy group-containing high molecular compound includes, among others, phenolic resins, polyhydroxystyrene and so on.

The proportions of components (b) and (c) of the photoresist composition of the invention based on 100 to 5 weight parts, preferably 100 to 50 weight parts, of component (a) are 0 to 95 weight parts, preferably 0 to 50 weight parts, for component (b) and 1 to 100 weight parts, preferably 5 to 50 weight parts, for component·(c).

The component (c) to be used in the present invention may be incorporated, as a discrete compound, in the composition of the invention or alternatively incorporated as the reaction product of the hydroxyl group of component (a) or/and component (b) with said benzoquinonediazide-sulfonyl chloride or naphthoquinonediazide-sulfonyl chloride. The proportion of said naphthoquinonediazide-sulfonyl chloride, for instance, is 0.5 to 70 parts by weight relative to 100 parts by weight of components (a) and (b) combined and not more than one equivalent relative to the total hydroxyl content of componets (a) and (b).

Another exemplary method for previously introduocing the positive sensitizer (c) into the block copolymer as component (a) comprises using a quinonediazide groupcontaining radical polymerizable unsaturated monomer as the monomer for the preparation of the component (a) polymer, for example the above-mentioned $M^1$ monomer. The quinonediazide group-containing monomer can be produced, for example, by subjecting unsaturated monomers containing one polymerizable unsaturated group and one or more urethane bonds per molecule to condensation-addition reaction with a halide (preferably the chloride) of orthobenzoquinonediazidosulfonic acid and/or orthonaphthoquinonediazidosulfonic acid. In order to prevent decomposition of the quinonediazide group, this reaction is preferably conducted in the absence of alcohol, water and the like at a temperature not exceeding 60 °C. Moreover, this quiononediazide group-containing monomer is preferably incorporated in a proportion of 20 to 70 weight % in the component (a) block copolymer.

When cation electrodeposition is to be carried out using an amino group-containing block copolymer as component (a), it is possible to introduce quinoneazide groups into the component (a) polymer so as to enable alkali development.

When the photoresist composition is to be used as a dry film, the $\{M^2\}_n$ segment constituting said component (a) is preferably one formed by polymerizing radical polymerizable monomers component containing at least 40 mole % of a carboxy group-containing radical polymerizable unsaturated monomer and, in this case, the porportions of the respective components are 95 to 5 parts by weight, preferably 90 to 10 parts by weight, of component (a), 5 to 95 parts by weight, preferably 10 to 90 parts by weight, of component (b), and 1 to 100 parts by weight, preferably 5 to 50 parts by weight, of component (c).

The proportion of component (c) which is previously reacted with, or introduced into, component (a) or/and component (b) is the proportion of component (c) used relative to component (a) or/and (b) prior to the reaction or introduction.

In the photoresist composition of the invention, other components may be incorporated in addition to said components (a) through (c). For example, a small proportion of other resin may be added for improving the adhesiveness of the composition. Moreover, a plasticizer, pigment, dye, stabilizer and/or a light absorber may also be incorporated.

For the purpose of enhancing the mechanical strength and chemical resistance of the composition, a small amount (for example, not more than 20 parts by weight) of a crosslinking agent, such as an epoxy resin or diisocyanate compound, may be incorporated unless the amount is so great to sacrifice the effect of the composition of the invention. For the crosslinking of the composition of the invention, it is possible to employ not more than 10 parts by weight of glycidyl methacrylate or glycidyl acrylate as said monomer $M^1$ for the formation of component (a) and causing it to crosslink with the carboxyl group of said monomer $M^2$. Furthermore, such crosslinking reaction may be effected by using not more than 10 parts by weight of divinylbenzene or a dihydric alcohol diacrylic ester or dimethacrylic ester as said monomer $M^1$. It is, of course, to be understood that the crosslinking by any such procedure should be limited to the extent that the exposed area may be readily removed by dissolution or swelling with an alkaline developer.

For the formation of a dry film from the photoresist compositon of the invention, a solution of the composition in an organic solvent is coated on a support film and dried. The support film includes, inter alia, films of polyamides, polyolefins, polyesters, celulose derivatives and vinyl polymers. Particularly preferred is a transparent polyethylene terephthalate film. The coating thickness of the composition on the support film is 3 to 250 µm, preferably 5 to 80 µm, on a dry film basis. To the film (dry film) thus formed from the composition of the invention on the support film, there may be laminated a protective film which may be a

polymer film similar to the support film. The protective film is preferably a polyethylene film.

To apply the dry film thus obtained to a metal-clad substrate board, the protective film is first peeled off and, with the support film up, the resist film side is mated with the metal foil. Then, the metal foil is heated or the assembly is pressed with a hot roll at a temperature which softens but does not degrade the dry film resist. The heating temperature is generally 50 to 180 °C and preferably 80 to 160 °C.

On the dry film photoresist composition laminated to the metal-clad substrate board, a positive-patterned mask film is superimposed. After exposure, the protective film is peeled off and the resist in the exposed area is removed with an alkaline developer. It is a preferred procedure to peel off the protective film prior to exposure and perform exposure through a mask film set directly on the resist film, for the procedure is conducive to a further improvement in resolution.

The alkaline developer may for example be an aqueous solution of sodium carbonate, sodium hydroxide or sodium phosphate or an aqueous solution of an organic base such as tetramethylammonium hydroxide or choline.

The positive-acting photoresist composition of the invention is used in anion electrodeposition when it contains a carboxyl group-containing block copolymer and in cation electrodeposition when it contains an amino group-containing block copolymer.

In order that anion electrodeposition can be effected using a positive-acting photoresist composition containing a carboxyl group-containing block copolymer, it is necessary to solubilize (make dispersible in water) the carboxyl group-containing block copolymer. This solubilization is effected by neutralizing the carboxyl groups contained in the block copolymer with an alkali (a neutralizer). Examples of such neutralizer are alkanolamines such as monoethanolamine, diethanolamine, triethanolamine, etc., alkylamines such as triethylamine, diethylamine, monoethylamine, diisopropylamine, trimethylamine, diisobutylamine, etc., alkylalkanolamines such as dimethylaminoethanol, etc., alicyclic amines such as cyclohexylamine, etc., alkai metal hydroxides such as sodium hydroxide, potassium hydroxide, etc., and ammonia. These neutralizers can be used independently or in combination of two or more. The amount of such neutralizer is preferably in the range of 0.4 to 1.0 mole equivalent per carboxyl group contained in the block copolymer. If the amount of the neutralizer is too small, the water dispersibility will be decreased to adversely affect the quality of electrodeposition while an excess of the neutralizer sacrifices the shelf-life of the composition.

For cation electrodeposition using a positive-acting photoresist composition containing an amino group-containing block copolymer, it is necessary to solubilize (make dispersible in water) the amino group-containing block copolymer. This solubilization is effected by neutralizing the amino groups of the block copolymer with an organic acid or an inorganic acid. The organic acid which can be used for such neutralization includes acetic acid, lactic acid, etc., while the inorganic acid may for example be phosphoric acid. The amount of the acid for neutralization is preferably 0.1 to 1.0 mole equivalent per amino group in the block copolymer. If the amount of acid is too small, the water dispersibility is decreased to interfere with electrodeposition, while an excess of acid detracts from the shelf-life of the composition.

In solubilizing the positive-acting photoresist composition of the invention to prepare an electrodeposition coating as described above, a hydrophilic solvent may be added to the composition in order to assist in the solublilization (dispersion) in water and to further improve the fluidity of the coating. The hydrophilic solvent mentioned just above includes, inter alia, isopropyl alcohol, n-butanol, t-butanol, methoxyethanol, ethoxyethanol, butoxyethanol, diethylene glycol, methyl ether, dioxane and tetrahydrofuran. The amount of such hydrophilic solvent is preferably not more than 300 parts by weight relative to 100 parts by weight of the block copolymer.

In order to increase the coating coverage, the electrodeposition coating may contain a hydrophobic solvent such as petroleum-based solvents (e.g. toluene, xylene, etc.), ketones (methyl ethyl ketone, methyl isobutyl ketone, etc.), esters (ethyl acetate, butyl acetate, etc.) and alcohols (e.g. 2-ethylhexyl alcohol, etc.). The amount of such hydrophobic solvent is preferably not more than 200 parts by weight relative to 100 parts by weight of the block copolymer.

For anion electrodeposition using a coating material prepared using a positive-acting photoresist composition containing a carboxyl group-containing block copolymer, a printed circuit board carrying a copper plating on a copper foil-clad insulating support, for instance, is immersed as the cathode in an electrodeposition bath at pH 5 to 10, a bath concentration (nonvolatile matter) of 3 to 30% by weight, preferably 5 to 15% by weight, and a bath temperature of 15 to 40 °C, preferably 15 to 30 °C, and a direct current voltage of 20 to 400 V is applied. The current time may range from 30 seconds to 5 minutes and the deposition thickness is generally 2 to 10 µm and preferably 3 to 30 µm on a dry basis.

For cation electrodeposition using a coating material prepared using a positive-acting photoresist composition containing an amino group-containing block copolymer, a printed circuit board carrying a copper plating on a copper foil-clad insulating support, for instance, is immersed as an anode in an

electrodeposition bath controlled at pH 3 to 9, a bath concentration (nonvolatile matter) of 3 to 30% by weight, preferably 5 to 15% by weight, and a bath temperature of 15 to 40 °C, preferably 15 to 30 °C, and a direct current voltage of 20 to 400 V is applied. The current time may range from 30 seconds to 5 minutes and the coating thickness is 2 to 100 µm and preferably 3 to 30 µm on a dry film basis.

The printed circuit board coated by the above anion or cation electrodeposition technique using a positive-acting photoresist composition is removed from the bath, rinsed and dried, for example with a hot air current, to remove the moisture, etc. from the coating film.

Then, a pattern mask (photographic positive) is superimposed on the coating film formed on the board, i.e. a photocurable electrodeposition coating film, and irradiated with actinic radiation for selective exposure of the unwanted area other than the conductor circuit.

Since the orthoquinone diazide compound in the exposed area is converted to the carboxylic acid via the ketene compound, this area is removed by development using a developer such as an aqueous alkali solution, whereby a circuit image of high resolution is obtained. The above development is preferably carried out by spraying an aqueous alkali solution as mentioned before against the exposed coating surface to wash out the sensitized area.

The positive-acting photoresist composition of the present invention can be easily electrodeposited on metal substrates such as copper foil and form a thin and uniform resist film.

The photoresist composition of the present invention which employs a defined block copolymer as a binder resin is excellent in adhesion to metal foil and tack-free even at temperatures slightly above room temperature. Therefore, the resist film can be exposed through a mask film directly placed thereon, thus permitting a high-fidelity pattern exposure. Moreover, the photoresist composition insures an improved pattern accuracy because of improved adhesion to metal foil and high film strength and etching resistance.

The following examples of synthesis of copolymers and polyphenols, working examples and comparative examples are intended to illustrate the present invention in further detail and should by no means be construed as defining the metes and bounds of the invention.

<u>Example of Synthesis of a Copolymer-1</u>

To 2.0 g of p-xylylenebis(N,N-diethyldithiocarbamate) of the following formula was added 368 g of butyl acrylate and 168 g of hydroxyethyl acrylate.

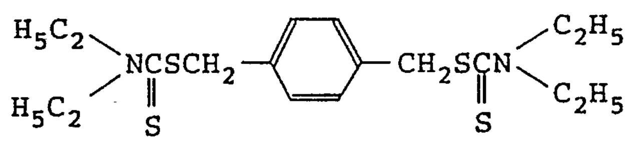

Then, a pyrex glass flask of 1 ℓ capacity was filled with the resulting solution and after thorough $N_2$ purging and sealing, was irradiated with ultraviolet light from a 400 W UV lamp (Toshiba Liteck Co., 400 L mercury-vapor lamp) positioned at a distance of 15 cm for about 10 hours. The polymer yield was 528 g. As determined by gel permeation chromatography, this polymer had a number average molecular weight (Mn) of 108,200 and a weight average molecular weight (Mw) of 201,000.

To 270 g of this product polymer were added 30 g of acrylic acid and 300 g of toluene, followed by thorough stirring to dissolve the polymer. Then, a further polymerization reaction was conducted for 10 hours by UV irradiation under the same conditions as above. The resulting slurry was purified by reprecipitation from 20 ℓ of hexane and dried in vacuo. The polymer yield was 288 g. The molecular weights determined as above were Mn = 120,000 and Mw = 246,000. This polymer had a blocking rate of 88.0% and an acid value of 78.

This block copolyemr was an ABA block copolymer, with the degrees of polymerization being 80 for block A and 870 for block B.

<u>Example of synthesis of a copolymer-2</u>

368 g of butyl acrylate was added 168 g of hydroxyethyl acyrlate and, after dissolution, 30 g of a

polymeric peroxide of the following structural formula

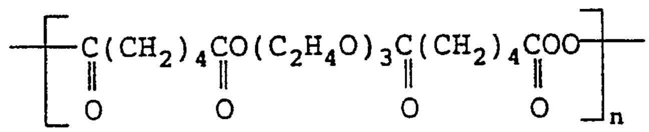

was added as a polymerization initiator. This polylmeric peroxide had an average degree of condensation of $\bar{n}$ = 4.5, a theoretical amount of active oxygen 3.96 and a selected 10-hour half-life temperature of 63.5° C (of. JP-A-61-287915). After thorough stirring, the mixture was put in a flask containing 1,200 g of toluene and the polymerization reaction was carried out at 60 to 80° C for 5 hours.

Then, 60 g of acrylic acid was added and the polymerization was further conducted at a temperature of 70 to 85° C for 10 hours. This slurry was purified by reprecipitation from 36 ℓ of hexane and the resulting polymer was dried in vacuo. The polymer yield was 566 g. Mn = 95,000, Mw = 294,000, blocking rate = 63%, acid value = 79.

This block copolymer was an AB block copolymer, with the degrees of polymerization being 690 for block A and 130 for block B.

## Example of Synthesis of a copolvmer 3

To 0.6 g of benzyl N,N-diethyldithiocarbamate of the following structural formula were added 280 g of n-butyl acrylate and 20 g of glycidyl methacrylate.

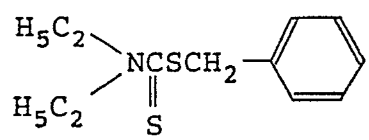

Then, a pyrex glass flask of 1 ℓ capacity was filled with the resulting solution and after sufficient $N_2$ purging and sealing, was irradiated with UV light from a 400 W UV lamp (the same as one used in Example of Synthesis of a Copolymer-1) positioned at a distance of 10 cm for about 10 hours. The resulting resin had a number average molecular weight of Mn = $6.8 \times 10^4$ and a weight average molecular weight of Mw = $12.2 \times 10^4$.

To this product was added 100 g of 2-ethylhexyl acrylate and, after $N_2$ purging and sealing, was irradiated with ultraviolet light in the same manner as above. The molecular weights of this resin were Mn = $8.4 \times 10^4$ and Mw = $16.0 \times 10^4$.

To this resin was added 400 g of toluene, followed by addition of 60 g of acrylic acid. After $N_2$ purging and UV irradiation as above, the product slurry was purified by reprecipitation from 20 ℓ of hexane and dried to give 427 g of resin. Mn = $9.2 \times 10^4$, Mw = $19.9 \times 10^4$, blocking rate = 87%, acid value = 101.

This resin was an ABA′ block copolymer, with the degrees of polymerization being 530 for block A, 140 for block B and 110 for block A′.

## Example of Synthesis of a Copolymer-4

In 1,200 g of toluene were dissolved 368 g of butyl acrylate, 168 g of hydroxyethyl acrylate and 60 g of acrylic acid followed by addition of 9 g of azobisisobutyronitrile. Nitrogen gas was bubbled through this solution for sufficient purging and the reaction was conducted at 80° C for 10 hours.

The resulting slurry was purified by reprecipitation from 36 ℓ of hexane and dried in vacuo.

The polymer yield was 570 g. Mn = 106,000, Mn = 329,000. This resin was a random copolymer with an acid value of 78.

## Example of Synthesis of a polyphenol-A

A reactor equipped with a reflux condenser, stirrer, thermometer and drip funnel was charged with 272.5 g of m-cresol and 272.5 g of p-cresol. Then, solution of 239 g of 37% aqueous formaldehyde solution and 7.3 g of oxalic acid dihydrate in 60 ml of water was added thereto and the reaction was carried out at 100° C for 5 hours. Then the internal temperature was increased gradually to 200° C with the by-product water being distilled off in nitrogen gas streams. Thereafter, the internal pressure was decreased to 5 mmHg so as to remove the volatile matter. The procedure gave 375 g of a polyphenol. This polyphenol had a softening point of 115° C.

Example of synthesis of a Polyphenol-B

A separable flask was filled with 108 g of o-cresol and 30 g of trioxane followed by addition of 500 g of ethylene glycol monoethyl ether. The mixture was heated at 100° C and 10 g of concentrated sulfuric acid was added. The reaction was then conducted at 110° C for 5 hours. Thereafter, the reaction mixture was poured in 3.6 ℓ of water containing 38 g of sodium carbonate with intense stirring and the resulting resinous polyphenol was filtered.

This resin was rinsed and dried in vacuo. Using a Soxhlet extractor, this resin was extracted with toluene for 24 hours to remove the toluene-soluble fraction (low molecular novolak resin). The residual resin was dried in vacuo to give 65 g of a product. This product resin had a number average molecular weight of Mn = 6,300, a weight average molecualr weight of Mw = 12,300, a Q value of 1.95 and a microscopic softening point of 185° C.

Example of Synthesis of a polvphenol-C

A three-necked separable flask of 500 ml capacity was filled with 108 g of m-cresol, 43.2 g of p-cresol and 136.8 g of bisphenol A (the mole ratio of m-cresol/p-cresol/bisphenol A 50/20/30) followed by addition of 146 g of 37 wt. % aqueous formalin solution and 1 g of oxalic acid. Then, the separable flask was heated on an oil bath with stirring and the reaction was conducted at a controlled internal temperature of 100° C for 90 minutes. The oil bath temperature was then increased to 180° C and the internal pressure was decreased to 5 mmHg to remove the water and unreacted substances. The novolak resin slurry thus formed was cooled to room temperature and 264 g of product resin was recovered. This polyphenol had a softening point of 110° C.

Example of Synthesis of a Polyphenol-D

A reactor equipped with a reflux condensor, stirrer, thermometer and drip funnel was charged with 1,296 g (12 moles) of m-cresol and 976 g (8 moles) of salicylaldehyde and the contents were heated to 80° C with stirring. Then 26 g of concentrated hydrochloric acid was slowly added from the drip funnel and with care exercised to prevent evolution of intensive heat, the temperature was increased to 100° C and the reaction was conducted at this temperature for 3 hours.

Then, the reflux condensor of the reactor was replaced with a cooling separator and the internal temperature was increased to 150° C and, then, to 190° C under a reduced pressure of 5 mmHg to distill off the hydrochloric acid, water and unreacted cresol. The procedure yielded 1,965 g of polyphenol. This resin had a microscopic softening point of 135° C.

Examples 1 and 2

In 160 parts of acetone-ethyl acetate (1:1, w/w) were dissolved 65 parts (by weight; the same applies hereafter) of the block polymer prepared in Example of Synthesis of a Copolymer-1 or -2, 35 parts of the

polyphenol prepared in Example of Synthesis of a Polyphenol-A and 5 parts of 2,4-dihydroxybenzophenonebis[naphthoquinone-(1,2)-diazide-(2)-5-sulfonate].

Using a doctor blade, each of the solutions was coated on a 25 µm thick polyethylene terephthalate film and dried at 100° C for 5 minutes to give a coating film having a thickness of 25 µm. As a protective film, a 25 µm thick polyethylene film was laminated to the coating film to give a dry film photoresist.

From each of the dry film photoresists thus prepared, the polyethylene film was peeled off and the photoresist was superimposed on the copper foil surface of a copper-clad laminate board. Using a roll preheated to 110° C, the polyethylene terephthalate support film was compressed to cause the photoresist into intimate contact with the copper foil surface. Then, the support film was peeled off and a mask film carrying a positive pattern was superimposed on the photoresist surface and a light exposure was carried out by irradiating the assembly with a 500 W high-pressure mercury-vapor lamp positioned at an overhead position about 40 cm away for 3 minutes. After exposure, development was carried out with a 5% aqueous solution of trisodium phosphate to dissolve out the exposed resist and thereby form a pattern. This laminate was then etched with a ferric chloride etching solution of 45° Bc to give a circuit pattern. The resist layer was dissolved off with a commercial stripping solution (methanol:dichloromethane = 10:90 w/w).

The characteristics of the positive-acting dry film photoresists according to the respective examples are shown in Table 1.

## Example 3

A dry film photoresist composition was prepared using the block copolymer of Example of Synthesis of a Copolymer-3 in otherwise the same manner as Examples 1 and 2. The dry film obtained was superimposed on the copper foil of a substrate board and heated at 140° C for 15 minutes, whereupon mild crosslinking occurred due to the reaction of the glycidyl group and the carboxyl group. As a result, a high adhesive strength could be established. When the product was exposed and developed in the same manner as Examples 1 and 2, the undercut by the alkaline developer was precluded. The characteristics of this photoresist are shown in Table 1.

## Examples 4 to 6

A circuit pattern was formed on a laminated substrate board using the block copolymer obtained in Example of Synthesis of a Copolymer-1 and one of the polyphenols prepared in Examples of Syntheses of Polyphenols-B through -D in otherwise the same manner as Examples 1 and 2. The characteristics of the photoresists thus manufactured are shown in Table 1.

## Example 7

In 400 g of dioxane was dissolved 200 g of the block copolymer resin prepared in Example of Synthesis of a Copolymer-1. To this solution was added 24 g of naphthoquinone-(1,2)-diazide-(2)-5-sulfonyl chloride followed by addition of 50 g of a 10% aqueous solution of sodium carbonate for conversion of hydroxyethyl group in the block copolymer resin to quinonediazide sulfonate ester. The precipitated sodium chloride was filtered off and the filtrate was purified by reprecipitation from 10 ℓ of hexane.

To 75 parts of the resulting naphthoquinonediazide-containing block copolymer resin were added 25 parts of the polyphenol prepared in Example of Synthesis of a Polyphenol-A and 160 parts of acetone-ethyl acetate (1:1, w/w) for dissolution. Using the resulting photoresist composition, a circuit pattern was formed in otherwise the same manner as Examples 1 and 2. The characteristics of the photoresist are shown in Table 1.

## Comparative Example 1

Using 65 parts of the random copolymer resin prepared in Example of Synthesis of a Copolymer-4 and 35 parts of the polyphenol prepared in Example of Synthesis of a Polyphenol-A, a dry film photoresist was fabricated in otherwise the same manner as Examples 1 and 2. A circuit pattern was formed in the same manner as Examples 1 and 2. The characteristics of this photoresist are shown in Table 1.

Table 1

| | Example | | | | | | | Comparative Example 1 |
|---|---|---|---|---|---|---|---|---|
| | 1 | 2 | 3 | 4 | 5 | 6 | 7 | |
| Tackiness*1 (35° C) | O | O | O | O | O | O | O | × |
| Adhesion*2 (g/cm) | 600 | 500 | 650 | 620 | 600 | 590 | 600 | 250 |
| Etching resistance (70° C) | O | O | O | O | O | O | O | × |
| Minimum pattern width*4 (μm) | 35 | 35 | 35 | 20 | 25 | 15 | 35 | 80 |

Notes to Table 1

The methods of determination and the evaluation criteria are as follows.

(1) Tackiness (*1)

At a controlled room temperature of 35° C, a mask film was superimposed on the resist film and, after exposure, the mask film was examined and evaluated according to the following criteria.
o : The mask film was not fouled.
x : The mask film was fouled.

(2) Adhesion (*2)

The resist film was stuck to a copper-clad laminate board having a width of 3 cm and the peeling strength was measured with a tensile tester.

(3) Etching resistnace (*3)

The resist film was immersed in a ferric chloride etching solution (45° Be) at 70° C for 1 hr. Then, the film was examined and evaluated according to the following criteria.
o: The resist film was not blistered, cracked or exfoliated.
x: The resist film was blistered, cracked and/or exfoliated.

(4) Minimum pattern width (*4)

Each photoresist was evaluated in terms of the minimum line width with which a satisfactory pattern of good adhesion and without defects could be constructed by the procedure described in examples.

It will be apparent from Table 1 that, even at a high room temperature of 35° C, the photoresists according to Examples did not show tackiness to soil the mask film, exhibited high-strength adhesion to copper foil and excellent resistance to the etching solution, and thus enabled to provide fine-line circuits.

Example of synthesis of a Copolymer-5

To 2.0 g of p-xylylenebis(N,N-diethyldithiocarbamate) of the following formula

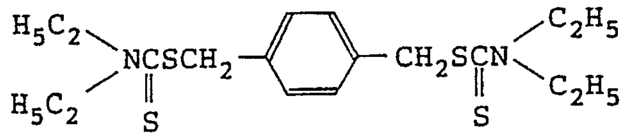

were added 268 g of methyl methacrylate and 284 g of hydroxyethyl acrylate and a pyrex glass flask of 1 ℓ capacity was charged with the resulting solution. After sufficient $N_2$ purging, the flask was sealed and irradiated with ultraviolet light from a 400 W UV lamp (Toshiba Liteck, 400 PL mercury-vapor lamp) positioned at a distance of 15 cm for about 10 hours. The polymer yield was 528 g and as determined by gel permeation chromatography, the number average molecular weight (Mn) was 118,000 and the weight average molecular weight (Mw) was 221,000.

To 280 g of the above polymer were added 20 g of acrylic acid and 300 g of toluene followed by thorough stirring for dissolution and the polymerization reaction was conducted by UV irradiation under the same conditions as above for 10 hours. The resulting slurry was purified by reprecipitation from 20 ℓ of hexane and dried in vacuo. Yield 288 g, Mn = 123,000, and Mw = 240,000. This polymer had a blocking rate of 88.0% and an acid value of 52.

This product was an ABA block polymer, with the degrees of polymerization being 30 for block A and 960 for block B.

## Example of Synthesis of a Copolymer-6

A four-neck flask was filled with 116 parts of 2-hydroxyethyl acrylate and 99 parts of butyl isocyanate and the temperature was increased to 70° C. The mixture was stirred at this temperature for 5 hours and after confirming that the isocyanate value had decreased to 0, the temperature was decreased to 40° C. Then, the flask was charged with 100 parts of dioxane and 101 parts of triethylamine. Thereafter, a solution of 269 parts of orthonaphthoquinonediazidosulfonyl chloride in 800 parts of dioxane was added dropwise over one hour and the mixture was maintained at 40° C for 3 hours.

This solution was poured in deionized water to precipitate the reaction product. The solvent was then removed from the precipitate in a vacuum dryer to give an orthonaphthoquinonediazide group-containing unsaturated monomer.

To 380 g of this orthonaphthoquinonediazido group-containing unsaturated monomer (380 g) was added 600 g of ethylene glycol monoethyl ether for dissolution and, as a polymerizaiton initiator, 30 g of a polymeric peroxide of the structural formula

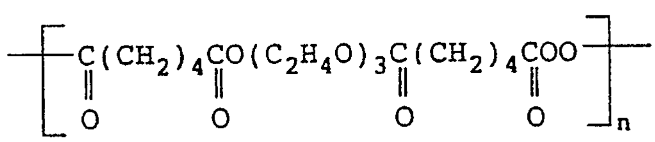

was added. This polymeric peroxide had an average degree of condensation n = 4.5, a theoretical active oxygen content of 3.96 and a selected 10-hour half-life temperature of 63.5° C (of. JP-A-61-287915). After thorough stirring, the mixture was placed in a flask and the polymerization reaction was conducted at 60 to 80° C for 5 hours.

Then, 300 g of methyl methacrylate, 150 g of n-butyl acrylate and 110 g of hydroxyethyl acrylate were added and the reaction was further continued under the same conditions for 5 hours.

Then, 60 g of acrylic acid was added and the polymerization reaction was further conducted at 70 to 85° C for 5 hours. The product was an ABA′ block copolymer with Mn = 140,000, Mw = 444,000, blocking rate = 61% and acid value = 46.

## Example of Synthesis of a Copolymer-7

To 0.6 g of benzyl-N,N-diethyldithiocarbamate of the following structural formula

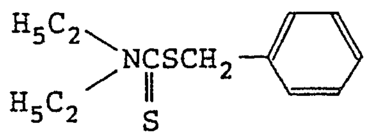

was added 300 g of methyl methacrylate and the resulting solution was put in a pyrex glass flask of 1 ℓ capacity. After thorough $N_2$ purging, the flask was hermetically closed and irradiated with ultraviolet light from a 400 W UV lamp (the same as used in Example of Synthesis of a Copolymer-1) positioned at a distance of 10 cm for about 10 hours. The procedure gave a resin with Mn = $6.5 \times 10^4$ and Mw = $11.8 \times 10^4$.

To this product was added 100 g of 2-ethylhexyl acrylate and, after $N_2$ purging, the mixture was irradiated with UV light in the same manner as above. This procedure yielded a resin with Mn = $8.1 \times 10^4$ and Mw = $15.6 \times 10^4$.

To the above product was added 400 g of toluene followed by addition of 300 g of glycidyl methacrylate. After $N_2$ purging and UV irradiation in the same manner as above, the product was purified by reprecipitation from 20 ℓ of hexane and dried to give 658 g of a resin with Mn = $1.31 \times 10^5$, Mw = $2.95 \times 10^5$ and a blocking rate of 87%.

This product was an ABA′ block copolymer, with the degrees of polymerization being 530 for block A, 140 for block B, and 300 for block A′.

## Example of Synthesis of a Copolymer-8

In 1,200 g of toluene were dissolved 268 g of methyl methacrylate, 284 g of hydroxyethyl acrylate and 37 g of acrylic acid followed by addition of 9 g of azobisisobutyronitrile. After sufficient purging by bubbling $N_2$ gas through the solution, the reaction was conducted at 80 °C for 10 hours.

This slurry was purified by reprecipitation from 36 ℓ of hexane and dried in vacuo.

The above procedure yielded 548 g of a polymer with Mn = 101,000 and Mw = 313,000. This polymer was a random copolymer with an acid value of 49.

## Example of Synthesis of a Copolymer-9

In 1,200 g of toluene were dissolved 300 g of methyl methacrylate, 100 g of 2-ethylhexyl acrylate and 300 g of glycidyl methacrylate followed by addition of 8 g of azobisisobutyronitrile. After sufficient purging by bubbling $N_2$ gas through the solution, the reaction was carried out at 80 °C for 10 hours.

The resulting slurry was purified by reprecipitation from 3.6 ℓ of hexane and dried in vacuo.

The procedure yielded 658 g of a polymer with Mn = 126,000 and Mw = 374,000. This resin was a random copolymer.

## Example 8

To 770 g of the block copolymer obtained in Example of Synthesis of a Copolymer-5 were added 269 g of orthonaphthoquinonediazidosulfonyl chloride, 5,200 g of dioxane, 1,000 g of deionized water and 358 g of 20 wt. % aqueous sodium hydroxide solution and the addition reaction was conducted at 50 °C with constant stirring for 5 hours. The reaction product was then poured in 20 ℓ of deionized water containing 78 g of 35% hydrochloric acid with stirring for neutralization and purified by the reprecipitation method. The precipitated resin was collected by filtration and dried to give 926 g of an orthonaphthoquinonediazide group-containing copolymer resin.

To 200 g of this resin was added 140 g of ethylene glycol monomethyl ether and the solution was neutralized with 9.2 g of triethylamine and diluted with deionized water to adjust the concentration of non-volatile matter to 15% to give an anion electrodeposition bath. The pH of the bath was 7.2.

Using a copper-clad laminate for a printed circuit board as the cathode, electrodeposition coating was carried out by passing a direct current of 100 V at a bath temperature of 25° C for 5 minutes. The resulting coating film was washed with water and dried at 50° C for 5 minutes to give a 10 µm-thick tack-free, smooth resist film.

Then, the resist film was irradiated through a patterned positive mask film with a 3 kW high-pressure mercury-vapor lamp in doses of 150 $mJ/cm^2$.

The exposed area was removed with 0.1% aqueous sodium carbonate solution at 25° C to effect development. The resulting resist image had a resolution of 15 µm.

Then, the resist material was rinsed and etched with a 37% (approx.) solution of ferric chloride (40° Bc) to give a circuit pattern. The resist layer was removed with a commercial stripping solution (a 10:90 (w/w) mixture of methonol and dichloromethane).

The resist film showed excellent adhesion, was free of defects and exfoliation, and exhibited satisfactory resistance to chemicals. The resist was free of peeling at the edge, so that a precision circuit pattern was obtained because of a high etching accuracy.

## Example 9

To 800 g of the resin solution obtained in Example of Synthesis of a Copolymer-6 was added 50 g of the polyphenol prepared in Example of Synthesis of a Polyphenol-B. The mixture was neutralized with 28 g of dimethylethanolamine and diluted with deionized water to adjust the concentration of non-volatile matter to 15% to give an anion electrodeposition bath. The bath had a pH value of 7.2.

Using a copper-clad laminate for a printed circuit board as the cathode, electrodeposition coating was performed by passing a direct current of 100 V at a bath temperature of 25° C for 5 minutes. The resulting coating film was washed with water and dried at 50° C for 5 minutes to give a 10 µm-thick tack-free, smooth resist film.

Then, exposure and development were carried out as in Example 8 to give a resist image with a resolution of 20 µm. Then, ferric chloride etching was performed in the same manner as Example 8.

On the other hand, the copper surface of a copper-clad laminate subjected to similar electrodeposition, exposure and development was soft-etched and rinsed. Thus, a 25% aqueous solution of Enplate PC-455 (the trademark of Japan Metal Finishing Co.) was maintained at 50° C and the board was immersed in the solution for 3 minutes. After rinse, the above developed board was dipped in a 15% ageuous solution of ammonium persulfate at 25° C for 1 minute. The board was taken out, rinsed and immersed in a 2% aqueous solution of sulfuric acid at 25° C for 1 minute. The board was then taken out and rinsed.

Throughout the above procedures, the resist film was free of defects and peeling and exhibited satisfactory resistance to chemicals. Moreover, since there is no edge exfoliation of the resist image, a precision circuit pattern was obtained.

## Example 10

In 400 g of ethylene glycol monoethyl ether was dissolved 500 g of the resin obtained in Example of Synthesis of a Copolymer-7, followed by addition of 14.6 g of a naphthoquinonediazide group-containing amino compound of the formula

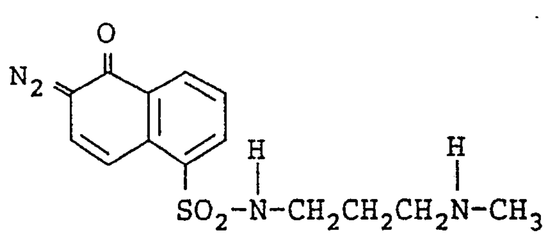

The mixture was heated at 50 °C for 1 hour, at the end of which time 10 g of diethylamine was added. The reaction was further conducted at 60 °C for 2 hours.

To this light-sensitive resin solution were added 55 g of the polyphenol resin obtained in Example of Synthesis of a Polyphenol-B and 5 g of 2,4-dihydroxybenzophenonebis(naphthoquinone-(1,2)-diazide-(2)-5sulfonate) followed by addition of 18 g of acetic acid for neutralization to give a cation electrodeposition bath. This bath had a pH value of 6.7.

Using a copper-clad laminate for a printed circuit board as the anode, electrodeposition coating was carried out by passing a direct current of 100 V at a bath temperature of 25 °C for 5 minutes. The coating film was washed with water and dried at 50 °C for 5 minutes to give a 10 µm-thick tack-free, smooth resist film.

Then, exposure and development were carried out as in Example 8, whereupon a resist image with a resolution of 15 µm was obtained.

Then, an etching test using ferric chloride and ammonium persulfate was carried out in the same manner as Example 9.

Throughout the above procedures, the resist film remained free of defects and peeling and exhibited high resistance to chemicals. Furthermore, since the resist image was free of edge exfoliation, a wholesome fine circuit pattern could be obtained.

## Comparative Example 2

An anion electrodeposition bath was prepared in the same manner as Example 8 except that the random copolymer obtained in Example of Synthesis of a Copolymer-8 was used.

As in Example 8, electrodeposition coating was carried out using a copper-clad laminate for a printed circuit board use as the cathode to give a 10 µm-thick resist film. Then, exposure and development were carried out as in Example 8 to give a resist image with a resolution of 30 µm. The image was, however, not as high as that of Example 8 in resolution.

Then, an etching test using ferric chloride was carried out as in Example 8. This resist film was so poor in strength and adhesion that it tended to suffer damage and exfoliation leading to a high incidence of rejects.

## Comparative Example 3

A cation electrodeposition bath was prepared in the same manner as Example 10 except that the random copolymer synthesized in Example of Synthesis of a Copolymer-9 was used.

Then, as in Example 10, electrodeposition coating was carried out using a copper-clad laminate for a printed circuit board use as the cathode to give a 10 µm-thick resist film, which was then exposed and developed to give a resist image with a resolution of 30 µm. This resist image was not as high as that of Example 10 in resolution.

Then, an etching test using ferric chloride and ammonium persulfate was carried out as in Example 10.

The resist film was so poor in strength and adhesion that it tended to suffer damage and exfoliation in the etching procedure leading to a high incidence of rejects.

The dry film photoresist according to the present invention is not tacky even at a comparatively high temperature and does not foul the mask film. It is also readily separable from the support film. Moreover, it is so flexible that it follows irregularities of the copper foil of the copper-clad laminate and is intimately bonded thereto without lifting or air entrapment. Furthermore, this photoresist shows excellent adhesion to copper foil and high resistance to etching solutions. Therefore, fine pattern circuits can be efficiently fabricated with the photoresist of the invention.

While the invention has been described in detail and with reference to specific embodiments thereof, it will be apparent to one skilled in the art that various changes and modifications can be made therein without departing from the spirit and scope thereof.

**Claims**

1. A positive-acting photoresist composition comprising

(a) 100 to 5 parts by weight of an AB or ABA block copolymer comprising a high molecular linear segment with a degree of polymerization in the range of 20 to 5,000 as derived from carboxy group (inclusive of anhydride thereof)-free and amino group-free radical polymerizable unsaturated monomors and a high molecular linear segment with a degree of polymerizaiton in the range of 20 to 5,000 as derived from radical polymerizable unsaturated monomers containing at least 40 mole % of a carboxy group (inclusive of anhydride thereof)- or amino group-containing radical polymerizable unsaturated monomer,

(b) 0 to 95 parts by weight of an alkali-soluble polyphenol, and

(c) 1 to 100 parts by weight of a positive sensitizer.

2. The photoresist composition as claimed in claim 1 wherein said positive sensitizer (c) is previously reacted or introduced into said block copolymer (a) and/or said alkali-soluble polyphenol (b).

3. The photoresist composition as claimed in claim 1 wherein said alkali-soluble polyphenol (b) is a novolak polyphenol as formed by condensation reaction between an alkyl-substituted phenol and an aldehyde.

4. The photoresist composition as claimed in claim 3 wherein said aldehyde is a hydroxy-aromatic aldehyde.

5. The photoresist composition as claimed in claim 1 wherein said positive sensitizer (c) is a quinone diazide compound.

6. A positive-acting dry film photoresist composition comprising

(a) 95 to 5 parts by weight of an AB or ABA block copolymer comprising a high molecular linear segment with a degree of polymerization in the range of 20 to 5,000 as derived from carboxy group (inclusive of anhydride thereof)-free and amino group-free radical polymerizable unsaturated monomers and a high molecular linear segment with a degree of polymerization in the range of 20 to 5,000 as derived from radical polymerizable unsaturated monomers containing at least 40 mole % of a carboxy group (inclusive of anhydride thereof)-containing radical polymerizable unsaturated monomer,

(b) 5 to 95 parts by weights of an alkali-soluble polyphenol, and

(c) 1 to 100 parts by weight of a positive sensitizer.

7. The photoresist composition as claimed in claim 6 wherein said alkali-soluble polyphenol (b) is a novolak polyphenol as formed by condensation reaction between an alkyl-substituted phenol and an aldehyde.

8. The photoresist composition as claimed in claim 6 wherein said alkali-soluble polyphenol (b) is a polyphenol formed by condensation reaction between a bisphenol and an aldehyde.

9. The photoresist composition as claimed in claim 7 wherein said aldehyde is formaldehyde.

10. The photoresist composition as claimed in claim 7 wherein said aldehyde is a hydroxy-aromatic aldehyde.

11. The photoresist composition as claimed in claim 6 wherein said positive sensitizer is a quinone diazide compound.

12. A method of use as a positive-acting photoresist composition in anion electrode position, which comprises dissolving a positive-acting photoresist composition in water, said positive-acting photoresist composition comprising

(a) 100 to 5 parts by weight of an AB or ABA block copolymer comprising a high molecular linear segment with a degree of polymerization in the range of 20 to 5,000 as derived from carboxy group (inclusive of anhydride thereof)-free and amino group-free radical polymerizable unsaturated monomors and a high molecular linear segment with a degree of polymerizaiton in the range of 20 to 5,000 as derived from radical polymerizable unsaturated monomers containing at least 40 mole % of a carboxy group (inclusive of anhydride thereof)-containing radical polymerizable unsaturated monomer,

(b) 0 to 95 parts by weight of an alkali-soluble polyphenol, and

(c) 1 to 100 parts by weight of a positive sensitizer.

13. A method of use as claimed in claim 12 wherein said positive sensitizer (c) is previously reacted or introduced into said block copolymer (a).

14. A method of use as a positive-acting photoresist composition in cation electrode position, which comprises dissolving a positive-acting photoresist composition in water, said positive-acting photoresist composition comprising

(a) 100 to 5 parts by weight of an AB or ABA block copolymer comprising a high molecular linear segment with a degree of polymerization in the range of 20 to 5,000 as derived from carboxy group (inclusive of anhydride thereof)-free and amino group-free radical polymerizable unsaturated monomors and a high molecular linear segment with a degree of polymerizaiton in the range of 20 to 5,000 as derived from radical polymerizable unsaturated monomers containing at least 40 mole % of an amino group-containing radical polymerizable unsaturated monomer,

(b) 0 to 95 parts by weight of an alkali-soluble polyphenol, and

(c) 1 to 100 parts by weight of a positive sensitizer.

15. A method of use as claimed in claim 14 wherein said positive sensitizer (c) is previously reacted or introduced into said block copolymer (a).